(19) Europäisches Patentamt
European Patent Office
Office européen des brevets

(11) **EP 3 047 290 B1**

(12) **FASCICULE DE BREVET EUROPEEN**

(45) Date de publication et mention de la délivrance du brevet:
**18.12.2019 Bulletin 2019/51**

(51) Int Cl.:
***G01R 31/36*** *(2019.01)*

(21) Numéro de dépôt: **14784304.9**

(22) Date de dépôt: **16.09.2014**

(86) Numéro de dépôt international:
**PCT/FR2014/052306**

(87) Numéro de publication internationale:
**WO 2015/040326 (26.03.2015 Gazette 2015/12)**

(54) **PROCEDE D'ESTIMATION DU VIEILLISSEMENT D'UNE CELLULE DE BATTERIE D'ACCUMULATEURS**

VERFAHREN ZUR SCHÄTZUNG DER ALTERUNG EINER ZELLE EINES AKKUMULATORS

METHOD FOR ESTIMATING THE AGEING OF A CELL OF A STORAGE BATTERY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.09.2013 FR 1358978**

(43) Date de publication de la demande:
**27.07.2016 Bulletin 2016/30**

(73) Titulaire: **Renault s.a.s**
**92100 Boulogne-Billancourt (FR)**

(72) Inventeurs:
• **GAGNEUR, Laurent**
**F-78180 Montigny le Bretonneux (FR)**
• **DRIEMEYER-FRANCO, Ana-Lucia**
**F-78180 Montigny le Bretonneux (FR)**
• **FORGEZ, Christophe**
**F-60200 Compiegne (FR)**

(56) Documents cités:
**FR-A1- 2 284 198     US-A1- 2005 057 255**

• **REMMLINGER JURGEN ET AL: "Identification of a bilinear and parameter-varying model for lithium-ion batteries by subspace methods", 2013 AMERICAN CONTROL CONFERENCE, IEEE, 17 juin 2013 (2013-06-17), pages 2268-2273, XP032476653, ISSN: 0743-1619 ISBN: 978-1-4799-0177-7 [extrait le 2013-08-14]**
• **CHENG K W E ET AL: "Battery-Management System (BMS) and SOC Development for Electrical Vehicles", IEEE TRANSACTIONS ON VEHICULAR TECHNOLOGY, IEEE SERVICE CENTER, PISCATAWAY, NJ, US, vol. 60, no. 1, 1 janvier 2011 (2011-01-01), pages 76-88, XP011342167, ISSN: 0018-9545, DOI: 10.1109/TVT.2010.2089647**
• **JÜRGEN REMMLINGER ET AL: "State-of-health monitoring of lithium-ion batteries in electric vehicles by on-board internal resistance estimation", JOURNAL OF POWER SOURCES, vol. 196, no. 12, 1 juin 2011 (2011-06-01) , pages 5357-5363, XP055022208, ISSN: 0378-7753, DOI: 10.1016/j.jpowsour.2010.08.035**

## Description

DOMAINE TECHNIQUE AUQUEL SE RAPPORTE L'INVENTION

La présente invention concerne de manière générale la gestion des cycles de charge et décharge d'une batterie d'accumulateurs.

Elle concerne plus particulièrement un procédé d'estimation du vieillissement d'au moins une cellule de batterie d'accumulateurs, comportant des étapes :

  a) d'acquisition d'une tension aux bornes de ladite cellule et d'une intensité du courant traversant ladite cellule, et
  b) de calcul d'une capacité maximale et d'un niveau de charge de ladite cellule en fonction de la tension et de l'intensité du courant acquises à l'étape a).

L'invention s'applique particulièrement avantageusement dans les véhicules automobiles équipés d'un moteur électrique alimenté par une batterie d'accumulateurs dite de traction.

ARRIERE-PLAN TECHNOLOGIQUE

De manière bien connue, la puissance électrique que peut fournir une batterie d'accumulateurs diminue au cours d'un cycle de décharge. La quantité maximale d'énergie que peut stocker la batterie d'accumulateurs diminue quant à elle progressivement au cours de la durée de vie de cette batterie.

Afin de tirer au mieux partie de la puissance électrique disponible dans la batterie pour alimenter un moteur électrique de véhicule automobile, afin de prédire l'autonomie résiduelle du véhicule avant une nouvelle charge de batterie, et afin de prévoir à quel moment il sera nécessaire de changer toute ou partie de la batterie, on cherche à déterminer deux paramètres particuliers de la batterie, que sont son niveau de charge noté SOC (acronyme anglais de "State Of Charge") et sa capacité maximale notée Q.

Le niveau de charge de la batterie, qui s'exprime généralement en pourcentage, traduit le niveau de chargement de la batterie entre un niveau de charge minimal où la batterie n'est plus utilisable, et un niveau de charge maximal.

La capacité maximale de la batterie, qui s'exprime généralement en ampère-heure, permet de connaître la durée pendant laquelle la batterie peut fournir un courant électrique d'un ampérage donné. Cette capacité se dégrade au cours du temps, en fonction notamment de l'historique de température de la batterie et de son historique de cycles de charge et décharge.

On connaît alors du document FR2971854 un procédé d'estimation de ce niveau de charge et de cette capacité maximale, utilisant un filtre de Kalman étendu dont la seule relation de base est constituée par l'équation suivante :

$$\frac{dSOC}{dt} = \frac{I}{Q},$$

avec I le courant traversant la batterie d'accumulateurs.

Les inconvénients majeurs de ce procédé d'estimation sont, d'une première part, son manque de précision et de fiabilité, d'une seconde part, sa non-détection d'une cellule défectueuse au sein de la batterie d'accumulateurs, et, d'une troisième part, son erreur d'interprétation concernant des variations réversibles de capacité considérées à tort comme étant dues au vieillissement.

Le document "Identification of a bilinear and parameter-varying model for lithium-ion batteries by subspace methods" (REMMLINGER JURGEN ET AL), bien qu'il suggère une modélisation assez précise des cellules d'une batterie, ne divulgue pas comment exploiter efficacement cette modélisation pour estimer de manière précise et fiable le niveau de charge, la capacité maximale ou encore le vieillissement d'une cellule.

OBJET DE L'INVENTION

Afin de remédier aux inconvénients précités de l'état de la technique, la présente invention propose un procédé d'estimation tel que défini dans l'introduction, dans lequel, à l'étape b), le calcul est réalisé par résolution :

- d'un système d'équations discrétisées correspondant à une modélisation de ladite cellule sous la forme d'un circuit électrique comportant, en série, une source de tension parfaite, une résistance, un premier couple de résistance et de capacité branchées en parallèle, et au moins un second couple de résistance et de capacité branchées en parallèle, et

- d'une équation discrétisée d'estimation de la variation de la capacité maximale de ladite cellule.

Selon l'invention, la cellule est donc modélisée par un circuit électrique.

La source de tension parfaite modélise alors le potentiel électrochimique de la cellule. La différence de potentiels aux bornes de cette source de tension parfaite dépend alors du niveau de charge de la cellule.

La résistance modélise la chute de tension induite par la connectique de la cellule et la résistance interne de la cellule.

Dans le premier couple de résistance et de capacité branchées en parallèle, la résistance modélise le phénomène de transfert de charge et la capacité représente le phénomène de double couche aux interfaces électrode/électrolyte. On appelle « phénomène de transfert de charge » le courant résultant des réactions d'oxydation et de réduction aux électrodes au sein de la cellule. On appelle « phénomène de double couche » le phénomène de séparation des charges ayant lieux à l'interface entre l'électrode et l'électrolyte.

Les autres couples de résistance et de capacité branchées en parallèle modélisent le phénomène de diffusion des ions lithium dans la cellule, c'est-à-dire la polarisation due au déplacement des ions dans l'électrolyte et à l'intérieur des électrodes.

Ainsi, les états de charge et capacités maximales sont calculées de manière fiable, au moyen d'un algorithme représentatif de la réalité électrochimique d'une cellule de batterie, qui converge rapidement vers des valeurs proches de la réalité.

Par ailleurs, grâce à l'invention, il est possible d'estimer la capacité maximale de chaque cellule de la batterie d'accumulateurs. Dès lors, une comparaison de ces différentes capacités maximales permettra de détecter une cellule défectueuse au sein de la batterie d'accumulateurs.

D'autres caractéristiques avantageuses et non limitatives du procédé d'estimation conforme à l'invention sont les suivantes :

- ledit système d'équations discrétisées s'exprime sous la forme suivante :

$$\begin{cases} SOC(k) = SOC(k-1) + \dfrac{(1+\Delta Q).I(k-1).T_e}{Q_n} \\[4mm] V_{dl}(k) = (1 - \dfrac{T_e}{R_{ct}C_{dl}}).V_{dl}(k-1) + \dfrac{I(k-1).T_e}{C_{dl}} \\[4mm] V_i(k) = (1 - \dfrac{T_e}{R_iC_i}).V_i(k-1) + \dfrac{I(k-1).T_e}{C_i}, \text{ avec } i = 1\dots N \end{cases}$$

$$V_{Cell}(k) = E_{eq}(SOC(k)) + R_\Omega.I(k) + V_{dl}(k) + \sum_{i=1}^{N} V_i(k)$$

avec $T_e$ une période d'échantillonnage considérée, k un indice incrémental, SOC le niveau de charge de ladite cellule, I l'intensité du courant traversant ladite cellule, $\Delta Q$ étant un paramètre relatif à une capacité nominale en début de vie et à la capacité maximale instantanée de ladite cellule, $V_{cell}$ la tension aux bornes du circuit électrique, $V_{dl}$ la tension aux bornes du premier couple de résistance et capacité, dont les valeurs sont respectivement notées $R_{ct}$ et $C_{dl}$, et $V_i$ la tension aux bornes du second couple de résistance et capacité, dont les valeurs sont respectivement notées $R_i$ et $C_i$ ;

- ladite équation discrétisée d'estimation de la variation de la capacité maximale de ladite cellule s'exprime en fonction d'un paramètre relatif à une capacité nominale en début de vie et à la capacité maximale instantanée de ladite cellule ;
- ladite équation discrétisée d'estimation de la variation de la capacité maximale de ladite cellule s'exprime sous la forme $\Delta Q(k) = \Delta Q(k-1)$, k étant un indice incrémental ;
- ladite équation discrétisée d'estimation de la variation de la capacité maximale de ladite cellule s'exprime sous la forme $\Delta Q(k) = g(SOC(k-1), \Delta Q(k-1), I(k-1), T(k-1))$, avec k un indice incrémental, g une fonction représentative de la dynamique de vieillissement de la cellule, SOC le niveau de charge de ladite cellule, I l'intensité du courant traversant ladite cellule, T une température mesurée sur ladite cellule ;
- à l'étape b), le calcul est réalisé en résolvant lesdites équations à l'aide d'un observateur d'état dont le vecteur d'état comporte le niveau de charge de ladite cellule, une variable représentative de la perte de capacité de ladite cellule, la tension aux bornes du premier couple de résistance et capacité, et la tension aux bornes de chaque second couple de résistance et capacité ;

- à l'étape b), le calcul est réalisé en résolvant lesdites équations à l'aide d'un observateur d'état dont le vecteur d'entrée comprend la tension aux bornes du circuit électrique ;
- il est prévu une étape supplémentaire c) de calcul d'un indicateur d'une perte d'autonomie de ladite cellule, en fonction de la capacité maximale de ladite cellule calculée à l'étape b) ;
- à l'étape c), la valeur dudit indicateur est modifiée seulement si l'estimation de la capacité maximale de ladite cellule est considérée comme convergée ;
- à l'étape c), la valeur dudit indicateur est modifiée seulement si la température mesurée de ladite batterie d'accumulateurs est comprise dans la plage de température de caractérisation en début de vie de ladite batterie d'accumulateurs ;
- à l'étape c), la valeur dudit indicateur d'état de santé est modifiée seulement si le niveau de charge de ladite batterie d'accumulateurs est compris dans une plage de caractérisation en début de vie de ladite batterie d'accumulateurs ;
- à l'étape c), la valeur dudit indicateur d'état de santé est modifiée seulement si la tension acquise à l'étape a) est comprise dans une plage de tension de caractérisation en début de vie de ladite batterie d'accumulateurs ; et
- à l'étape c), la valeur dudit indicateur d'état de santé est modifiée seulement si l'intensité acquise à l'étape a) est comprise dans une plage d'intensité de caractérisation en début de vie de ladite batterie d'accumulateurs.

## DESCRIPTION DETAILLEE D'UN EXEMPLE DE RÉALISATION

La description qui va suivre en regard des dessins annexés, donnés à titre d'exemples non limitatifs, fera bien comprendre en quoi consiste l'invention et comment elle peut être réalisée.

Sur les dessins annexés :

- la figure 1 est une vue schématique d'un véhicule automobile équipé d'une batterie d'accumulateurs comprenant une pluralité de cellules, et d'une unité de pilotage adaptée à mettre en œuvre un procédé d'estimation du vieillissement de ces cellules ;
- la figure 2 est un schéma électrique modélisant l'une des cellules de la batterie d'accumulateurs de la figure 1 ; et
- la figure 3 est un graphique illustrant, en pointillés, les variations de l'estimation de la capacité maximale de la cellule de la figure 2, en trait interrompu, les variations d'un indicateur intermédiaire d'état de santé, et, en trait continu, les variations d'un indicateur d'état de santé filtré.

En préliminaire, dans la suite de cet exposé, on entendra par « batterie d'accumulateurs » un élément apte à stocker de l'énergie électrique lorsqu'il est alimenté en courant par un réseau électrique extérieur, puis à restituer ultérieurement cette énergie électrique. Une telle batterie d'accumulateurs peut être par exemple de type électrochimique (par exemple Lithium-ion) ou d'un type différent (par exemple condensateur).

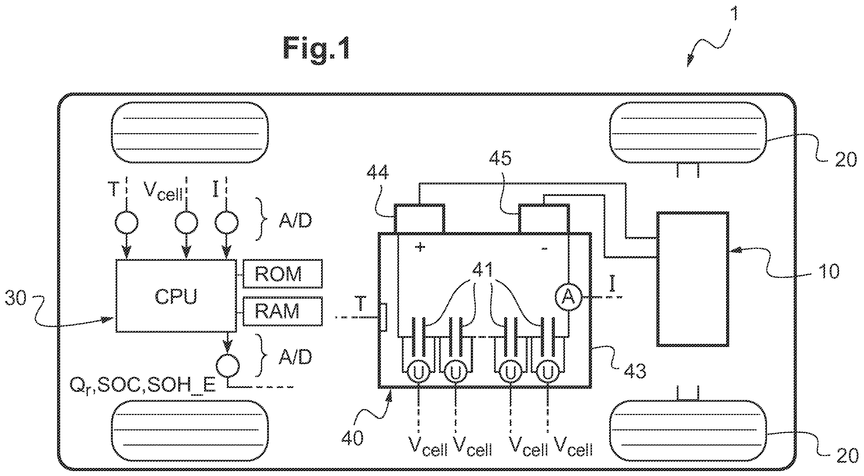

Sur la figure 1, on a représenté très schématiquement un véhicule automobile 1.

Ce véhicule automobile 1 est ici un véhicule électrique. Il comporte alors un moteur électrique 10 prévu pour entraîner en rotation ses roues motrices 20.

En variante, il pourrait s'agir d'un véhicule hybride, comportant un moteur à combustion interne et un moteur électrique pour l'entraînement de ses roues motrices.

Comme le montre la figure 1, le véhicule automobile 1 comporte une batterie d'accumulateurs, appelée batterie de traction 40.

Cette batterie de traction 40 est ici exclusivement prévue pour alimenter le moteur électrique 10 en courant. En variante, cette batterie de traction pourrait être également prévue pour alimenter en courant différents appareils électriques consommateurs de courant, tels que le système de direction assistée, le système de climatisation...

Cette batterie de traction 40 comporte un boîtier extérieur 43 duquel émergent deux bornes, une positive 44 et l'autre négative 45 connectées au moteur électrique 10 via un boîtier électronique de puissance (non représenté).

La batterie de traction 40 comporte également une pluralité de cellules 41 qui sont logées dans le boîtier extérieur 43 et qui sont ici branchées en série entre les deux bornes positive 44 et négative 45.

En variante, on pourrait prévoir que les cellules soient connectées par couples en parallèles, et que ces couples de cellules soient branchés en série entre les deux bornes positive et négative.

Le nombre de cellules 41 utilisées est déterminé de telle sorte que le moteur électrique 10 puisse développer un couple et une puissance suffisants pour propulser le véhicule automobile 1 pendant une durée prédéterminée.

Une cellule de batterie de traction délivrant habituellement une tension de l'ordre de 3 à 5 V, le nombre de cellules 41 est alors calculé de telle manière que la tension aux bornes de la batterie de traction 40 puisse atteindre 400 V.

Chaque cellule 41 de la batterie de traction 40 sera alors ici surveillée indépendamment des autres cellules 41. On caractérise à cet effet ici chaque cellule 41 par trois paramètres particuliers appelés niveau de charge SOC, capacité maximale $Q_r$ et indicateur d'état de santé SOH_E.

Le niveau de charge SOC s'exprime en pourcentage. Il traduit l'état de chargement de la cellule 41 considérée, entre un niveau de charge minimal où la batterie n'est plus utilisable (0 %), et un niveau de charge maximal (100 %).

La capacité maximale $Q_r$ s'exprime en ampère-heure. Elle indique la durée pendant laquelle la cellule 41 peut fournir un courant électrique d'un ampérage donné. Au moment de la fabrication de la cellule 41, cette capacité maximale $Q_r$ est généralement égale ou légèrement inférieure à la capacité nominale Qn pour laquelle la cellule a été conçue. Puis, elle se dégrade au cours du temps, en fonction notamment de l'historique de température de la cellule 41 et de son historique de cycles de charge et décharge.

L'indicateur d'état de santé SOH_E s'exprime en pourcentage. Il fournit une information quant au niveau de vieillissement de la cellule 41 considérée. En règle générale, au moment de la fabrication de la cellule 41, l'indicateur d'état de santé SOH_E est égal ou légèrement inférieur à 100%, puis il diminue avec le temps, selon l'utilisation qui est faite de la cellule 41.

Il s'avère alors essentiel, et c'est d'ailleurs l'objet de la présente invention, de déterminer précisément ces trois paramètres afin de surveiller le vieillissement de la batterie de traction 40 en vue de prévenir toute panne du véhicule automobile 1.

Pour cela, le véhicule automobile 1 comporte un calculateur 30, qui est ici représenté comme étant indépendant de la batterie de traction 40. En variante, ce calculateur pourrait être intégré à la batterie. Selon une autre variante, le calculateur pourrait faire partie intégrante de l'unité globale de pilotage du moteur électrique.

Ici, comme le montre la figure 1, le calculateur 30 comprend un processeur (CPU), une mémoire vive (RAM), une mémoire morte (ROM), des convertisseurs analogiques-numériques (A/D), et différentes interfaces d'entrée et de sortie.

Grâce à ses interfaces d'entrée, le calculateur 30 est adapté à recevoir de différents capteurs des signaux d'entrée relatifs à la batterie de traction 40.

Dans sa mémoire vive, le calculateur 30 mémorise ainsi en continu :

- la température T de la batterie de traction 40, mesurée ici à l'aide d'un capteur de température situé dans le boîtier extérieur 43 de la batterie de traction 40,
- l'intensité I du courant débité par la batterie de traction 40, à l'aide d'un capteur de courant connecté électriquement entre les cellules 41 et la borne négative 45 de la batterie de traction 40, et
- la tension $V_{cell}$ aux bornes de chaque cellule 41, à l'aide de voltmètres connectés électriquement aux bornes des cellules 41 de la batterie de traction 40.

Grâce à un logiciel mémorisé dans sa mémoire morte, le calculateur 30 est adapté à déterminer, en fonction des valeurs mesurées, le niveau de charge SOC, la capacité maximale $Q_r$, et l'indicateur d'état de santé SOH_E de chaque cellule 41.

Enfin, grâce à ses interfaces de sortie, le calculateur 30 est adapté à transmettre ces données à l'unité globale de pilotage du moteur électrique 10.

Ici, le fonctionnement du logiciel sera exposé en relation avec une seule cellule 41 de la batterie de traction 40. En pratique, il sera mis en œuvre de la même manière sur chacune des autres cellules de la batterie de traction 40.

Au démarrage, le calculateur 30 met en œuvre une opération d'initialisation au cours de laquelle il affecte des « valeurs initiales estimées » à différents paramètres, notamment au niveau de charge SOC, à la capacité maximale $Q_r$ et à l'indicateur d'état de santé SOH_E.

Ces valeurs initiales peuvent par exemple être choisies égales aux valeurs calculées au précédent cycle de fonction du moteur électrique 10.

Au premier démarrage du moteur, elles peuvent par exemple être choisies ainsi :

- SOC = 100 %,
- $Q_r = Q_n$, et
- SOH_E = 100%.

Le calculateur 30 met ensuite en œuvre un algorithme en quatre étapes, répétées de manière récurrente à chaque pas de temps (le pas de temps considéré étant ici noté k).

La première étape est une étape d'acquisition des paramètres de la cellule 41 considérée de la batterie de traction 40.

La seconde étape est une étape de calcul de la capacité maximale $Q_r$ et du niveau de charge SOC de la cellule 41.

La troisième étape est une étape de validation des données calculées.

La quatrième étape est une étape de calcul de l'indicateur d'état de santé SOH_E de la cellule 41 et d'un indicateur d'état de santé SOH_E de la batterie de traction 40.

Au cours de la première étape, le calculateur 30 acquiert les valeurs de la tension $V_{cell}$ aux bornes de la cellule 41 considérée, de l'intensité I du courant traversant cette cellule 41, et de la température T de la batterie de traction 40.

La seconde étape, qui consiste à calculer la capacité maximale $Q_r$ et le niveau de charge SOC de la cellule 41, est ici opérée au moyen d'un observateur d'état.

Un tel observateur d'état est utilisé pour reconstruire, à partir des mesures, les variables internes d'un système dynamique. L'observateur, à partir d'un modèle embarqué de la cellule et de la valeur du courant d'entrée prédit la tension de cette cellule. Il compare ensuite cette prédiction à la mesure de tension de la cellule. La différence entre tension prédite et tension mesurée est utilisée pour adapter les états internes du modèle et les faire converger de manière à annuler l'écart entre tension prédite et tension mesurée.

Ici, selon une caractéristique particulièrement avantageuse de l'invention, le calcul de la capacité maximale $Q_r$ et du niveau de charge SOC de la cellule 41 est réalisé par résolution :

- d'un système d'équations discrétisées correspondant à une modélisation de la cellule 41 sous la forme d'un circuit électrique 42 comportant, en série, une source de tension parfaite $E_{eq}$, une résistance $R_\Omega$, un premier couple de résistance $R_{ct}$ et de capacité $C_{dl}$ branchées en parallèle, et au moins un second couple de résistance $R_i$ et de capacité $C_i$ branchées en parallèle, et
- d'une équation discrétisée d'estimation de la variation de la capacité maximale $Q_r$ de la cellule 41.

Théoriquement, ces équations ont été élaborées de la manière suivante.

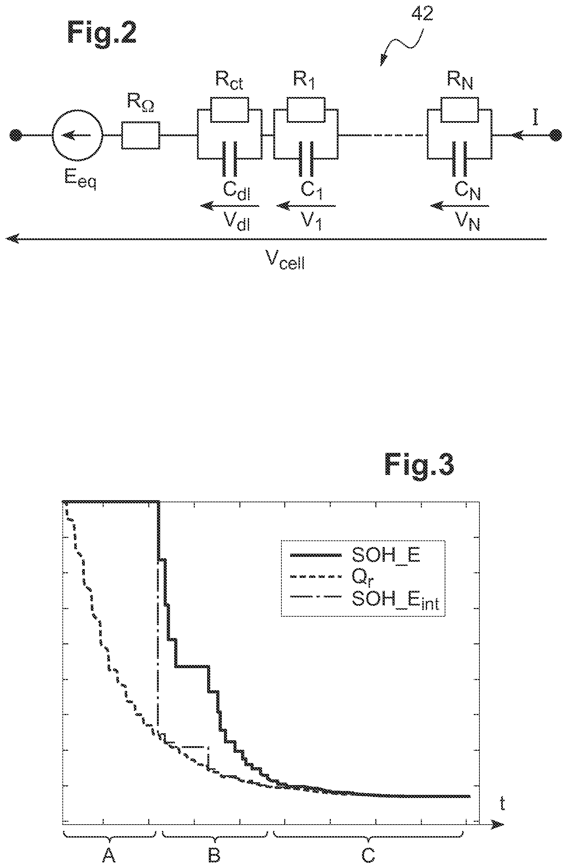

Comme le montre la figure 2, la cellule 41 est modélisée sous la forme d'un circuit électrique 42 comportant des composants idéaux.

Dans ce modèle, la source de tension parfaite $E_{eq}$ modélise le potentiel électrochimique de la cellule. La différence de potentiels aux bornes de cette source de tension parfaite $E_{eq}$ dépend alors directement du niveau de charge SOC de la cellule 41.

La résistance $R_\Omega$ modélise la chute de tension induite par la connectique de la cellule 41 et la résistance interne de la cellule 41.

Dans le premier couple de résistance $R_{ct}$ et de capacité $C_{dl}$ branchées en parallèle, la résistance $R_{ct}$ modélise le phénomène de transfert de charge et la capacité $C_{dl}$ représente le phénomène de double couche aux interfaces électrode/électrolyte. On note $V_{dl}$ la tension aux bornes de ce premier couple.

Il est ici prévu N couples de résistance $R_i$ et de capacité $C_i$ branchées en parallèle, avec i allant de 1 à N. Ces N couples modélisent le phénomène de diffusion des ions lithium dans la cellule 41 et dans les électrodes de la cellule 41. On note $V_i$ la tension aux bornes du ième couple. N peut par exemple être choisi égal à **2.**

La mise en équation de ce circuit électrique 42 équivalent conduit au système d'équations suivant :

$$\begin{cases} \dfrac{dSOC}{dt} = \dfrac{I}{Q_n} \\[2mm] \dfrac{dV_{dl}}{dt} = -\dfrac{V_{ctdl}}{R_{ct}C_{dl}} + \dfrac{I}{C_{dl}} \\[2mm] \dfrac{dV_i}{dt} = -\dfrac{V_i}{R_i C_i} + \dfrac{I}{C_i}, \text{pour } i = 1 \ldots N \end{cases}$$

$$V_{Cell} = E_{eq}(SOC) + R_\Omega . I + V_{ctdl} + \sum_{i=1}^{N} V_i$$

L'équation d'estimation de la variation de la capacité maximale $Q_r$ de la cellule 41 est quant à elle obtenue sur la base du constat suivant : tandis que le niveau de charge SOC évolue rapidement au cours d'un cycle de charge ou de décharge, que la tension $V_{dl}$ peut varier de 0V à quelques dixièmes de volts en quelques secondes, et que la polarisation de diffusion $\sum_{i=1}^{N} V_i$ peut passer de 0V à quelques dixièmes de volts en quelques minutes, la capacité maximale $Q_r$ de la cellule 41 varie très lentement (en moyenne, de l'ordre de 20 % en 5 ans).

De ce fait, l'hypothèse de considérer une variation de capacité maximale $Q_r$ nulle entre deux pas de temps est raisonnable. On écrit alors :

$$\frac{d\Delta Q}{dt} = 0 \, ,$$

avec

$$\Delta Q = \frac{Q_n}{Q_r} - 1 \, .$$

On notera ici que l'utilisation de ce paramètre $\Delta Q$ plutôt que la capacité maximale $Q_r$ améliorera le fonctionnement de l'algorithme et évitera des problèmes numériques pouvant entraîner sa divergence.

La discrétisation de ces équations permet d'obtenir le système suivant :

$$\begin{cases} SOC(k) = SOC(k-1) + \dfrac{(1+\Delta Q).I(k-1).T_e}{Q_n} \\ \Delta Q(k) = \Delta Q(k-1) \\ V_{cl}(k) = (1 - \dfrac{T_e}{R_{ct}C_{dl}}).V_{ctdl}(k-1) + \dfrac{I(k-1).T_e}{C_{dl}} \\ V_i(k) = (1 - \dfrac{T_e}{R_i C_i}).V_i(k-1) + \dfrac{I(k-1).T_e}{C_i}, avec\, i = 1 \dots N \end{cases}$$

$$V_{Cell}(k) = E_{eq}(SOC(k)) + R_\Omega.I(k) + V_{ctdl}(k) + \sum_{i=1}^{N} V_i(k)$$

Dans ce système d'équations, $T_e$ est la période d'échantillonnage.

L'observateur d'état ici utilisé pour obtenir à chaque pas de temps k une bonne évaluation de la capacité maximale $Q_r$ et du niveau de charge SOC de la cellule 41 est un filtre de Kalman étendu.

En pratique, le calculateur 30 met en œuvre une pluralité de calculs basés sur ce filtre de Kalman étendu afin d'obtenir des estimations de la capacité maximale $Q_r$ et du niveau de charge SOC de la cellule 41.

Ces calculs sont connus de l'homme du métier et ne seront donc pas décrits ici en détail. On pourra, pour plus de détail, se référer par exemple à l'ouvrage « Optimal State Estimation » de Dan Simon, publié aux éditions Wiley.

En résumé, cet observateur d'état utilise un vecteur d'état $x_k$, un vecteur d'entrée $u_k$, un vecteur de sortie $y_k$, un bruit d'état $\omega_k$, et un bruit de mesure $v_k$. Il considère alors le système stochastique suivant :

$$\begin{cases} x_k = f_{k-1}(x_{k-1}, u_{k-1}, \omega_{k-1}) \\ y_k = h_k(x_k, u_k, v_k) \\ \omega_k (0, Q_k) \\ v_k (0, R_k) \end{cases}$$

Dans ce système, $R_k$ est la matrice de covariance de bruit de mesure et $Q_k$ la matrice de covariance de bruit d'état. En pratique, le vecteur d'état $x_k$ est défini ainsi :

$$x_k = \begin{bmatrix} SOC(k) \\ \Delta Q(k) \\ V_{dl}(k) \\ V_1(k) \\ \vdots \\ V_N(k) \end{bmatrix}$$

Le vecteur de sortie $y_k$ est défini ainsi :

$$y_k = V_{cell}(k)$$

Le vecteur d'entrée $u_k$ est défini ainsi :

$$u_k = I(k)$$

Les fonctions $f_{k-1}$ et $h_k$ sont obtenues à l'aide du système d'équations discrétisées mentionné supra.

Le calculateur 30 linéarise alors le système d'équations en calculant les matrices jacobiennes suivantes :

$$F_{k-1} = \frac{\partial f_{k-1}}{\partial x}\bigg|_{\hat{x}_{k-1}^+}$$

$$L_{k-1} = \frac{\partial f_{k-1}}{\partial \omega}\bigg|_{\hat{x}_{k-1}^+}$$

Il estime alors la matrice de covariance d'erreur d'estimation de la variable d'état $P_k$ et la variable d'état $x_k$ de la manière suivante :

$$P_k^- = F_{k-1}P_{k-1}^+ F_{k-1}^T + L_{k-1}Q_{k-1}L_{k-1}^T$$

$$\hat{x}_k^- = f_{k-1}(\hat{x}_{k-1}^-, u_{k-1}, 0)$$

Le calculateur 30 linéarise alors ces équations en calculant les matrices jacobiennes suivantes :

$$H_k = \frac{\partial h_k}{\partial x}\bigg|_{\hat{x}_k^-}$$

$$M_k = \frac{\partial h_k}{\partial v}\bigg|_{\hat{x}_k^-}$$

Enfin, le calculateur 30 met à jour le gain de Kalman $K_k$, estime la variable d'état $x_k$ et la matrice de covariance d'erreur d'estimation de la variable d'état $P_k$ de la manière suivante :

$$K_k = P_k^- H_k^T (H_k P_k^- H_k^T + M_k R_k M_k^T)^{-1}$$

$$\hat{x}_k^+ = \hat{x}_k^- + K_k [y_k - h(\hat{x}_k^-, u_k, 0)]$$

$$P_k^+ = (I - P_k H_k) P_k^-$$

Le calculateur 30 obtient ainsi les valeurs de la capacité maximale $Q_r$ et du niveau de charge SOC de la cellule 41.

La précision de la modélisation permet le choix d'un paramétrage dynamique de l'observateur conduisant à une convergence rapide.

La troisième étape est une étape de validation des données calculées.

Cette étape consiste à vérifier, d'une part, si la valeur de la capacité maximale $Q_r$ calculée a suffisamment convergé pour être utilisable, et, d'autre part, si les conditions d'utilisation de la cellule 41 sont proches des conditions de sa caractérisation en début de vie (lorsque la capacité maximale $Q_r$ de la cellule était considérée égale à la capacité nominale $Q_n$). C'est-à-dire que nous disposons effectivement de données de comparaison permettant de conclure sur la perte irréversible de capacité. Pour vérifier que l'algorithme a suffisamment convergé, le calculateur 30 détermine la différence entre la dernière capacité maximale $Q_r(k)$ calculée, et la capacité maximale $Q_r(k-k')$ calculée quelques pas de temps auparavant, puis il estime que la capacité maximale $Q_r$ a suffisamment convergé si cette différence est inférieure à un seuil S0 prédéterminé.

Ici, le calculateur 30 considère que la capacité maximale $Q_r$ a suffisamment convergé si :

$$\left| Q_r(k) - Q_r(k-10) \right| < S0.$$

Pour vérifier que les conditions d'utilisation de la cellule 41 sont proches des conditions de caractérisation en début de vie de cette cellule, le calculateur 30 utilise au moins la température T(k) acquise à la première étape. Il utilise préférentiellement aussi les valeurs de tension $V_{cell}(k)$, de courant I(k) et de niveau de charge SOC(k).

Ici, le calculateur 30 considère que les conditions d'utilisation de la cellule 41 sont proches des conditions d'utilisation en début de vie de cette cellule si :

$$Tmin,carac < T(k) < Tmax,carac,$$

$$SOCmin,carac < SOC(k) < SOCmax,carac,$$

$$Vmin,carac < V(k) < Vmax,carac,$$

$$Imin,carac < I(k) < Imax,carac$$

avec Tmin,carac, Tmax,carac, SOCmin,carac, SOCmax,carac, Vmin,carac, Vmax,carac, Imin,carac et Imax,carac, respectivement les températures, états de charge, tension cellule et courant minimum et maximum de caractérisation.

Lorsque le calculateur 30 considère que la capacité maximale $Q_r$ a suffisamment convergé et que les conditions d'utilisation de la cellule 41 sont proches des conditions de caractérisation en début de vie de cette cellule, il affecte la valeur 1 à un indicateur de validité $\delta$. Sinon, il affecte à cet indicateur de validité $\delta$ la valeur 0.

Comme cela apparaîtra clairement dans la suite de cet exposé, l'utilisation de cet indicateur de validité $\delta$ et de l'indicateur d'état de santé SOH_E évite de considérer des variations réversibles de capacité maximale $Q_r$ comme étant dues au vieillissement.

La quatrième étape consiste à calculer l'indicateur d'état de santé SOH_E de la cellule 41, puis à en déduire l'indicateur d'état de santé SOH_E de la batterie de traction 40.

Pour cela un indicateur intermédiaire de vieillissement SOH_E$_{int}$ est calculé à l'aide de la formule suivante :

$$SOH\_E_{int}(k) = \delta \frac{Q_r(k)}{Q_n} + (1-\delta) SOH\_E_{int}(k-1)$$

Cet indicateur intermédiaire de vieillissement SOH_E$_{int}$ est ensuite filtré par un filtre de robustesse qui en limite les variations brusques. Il s'agit ici d'un filtre dit de « moyenne mobile ».

Grâce à ce filtre de robustesse, le calculateur 30 obtient l'indicateur d'état de santé SOH_E de la cellule 41.

Sur la figure 3, on a représenté les convergences de l'estimation de la capacité maximale Q$_r$, de l'indicateur intermédiaire de vieillissement SOH_E$_{int}$, et de l'indicateur d'état de santé SOH_E.

On observe sur cette figure que dans un premier temps (partie A), la capacité maximale Q$_r$ n'a pas encore convergé, si bien que l'indicateur de validité δ est maintenu égal à 0. De ce fait, les indicateurs de vieillissement SOH_E$_{int}$ et SOH_E ne varient pas.

Dans un second temps (partie B), le calculateur 30 estime que la capacité maximale Q$_r$ a convergé et affecte donc la valeur 1 à l'indicateur de validité δ. L'indicateur intermédiaire de vieillissement SOH_E$_{int}$ varie alors brusquement pour converger vers la valeur du rapport Q$_r$/Q$_n$. Grâce au filtre, l'indicateur d'état de santé SOH_E varie quant à lui moins brusquement, pour converger progressivement vers la valeur de ce rapport (partie C).

Enfin, le calculateur 30 détermine l'indicateur d'état de santé SOH_E de la batterie de traction 40.

Pour cela, le calculateur 30 affecte à l'indicateur d'état de santé SOH_E de la batterie de traction 40 la valeur de l'indicateur d'état de santé SOH_E de la cellule 41 qui a le plus vieilli, selon la formule suivante :

$$\text{SOH\_E}_{batterie} = \min(\text{SOH\_E}_{cellules}).$$

A ce stade, le calculateur 30 peut aussi déterminer de manière fiable si l'une des cellules 41 est défectueuse.

Pour cela, il compare les valeurs des indicateurs de vieillissement SOH_E de chaque cellule avec une valeur attendue. Cette valeur attendue peut par exemple être constituée par la moyenne des indicateurs de vieillissement SOH_E des cellules 41. Le calculateur 30 en déduit un dysfonctionnement si cet écart dépasse une valeur prédéterminée, par exemple égale à 30%.

La présente invention n'est nullement limitée au mode de réalisation décrit et représenté, mais l'homme du métier saura y apporter toute variante conforme à son esprit.

Ainsi, on pourrait par exemple prévoir que la température soit mesurée à l'aide d'un capteur placé contre la face externe du boîtier extérieur de la batterie de traction. On pourrait aussi prévoir d'utiliser plusieurs capteurs de température afin d'obtenir une meilleure estimation de la température au niveau de la cellule considérée.

Selon une autre variante, on aurait pu prévoir de considérer que l'indicateur d'état de santé de la cellule soit constitué par sa capacité maximale.

Encore en variante, on aurait pu utiliser un paramètre différent de ΔQ pour calculer le niveau de charge SOC et la capacité maximale Q$_r$. Ainsi, on aurait par exemple pu considérer un paramètre β égal au rapport de la capacité nominale Q$_n$ sur la capacité maximale Q$_r$ de la cellule.

Alors, l'équation discrétisée d'estimation de la variation de la capacité maximale Q$_r$ de la cellule 41 se serait exprimée sous la forme suivante :

$$\beta(k) = \beta(k-1), \text{ avec } \beta(k) = Q_n/Q_r(k).$$

Selon une autre variante, on aurait pu utiliser le paramètre ΔQ, en estimant toutefois que ce dernier varie légèrement entre deux pas de temps, en fonction par exemple de l'un ou l'autre des paramètres que sont le niveau de charge SOC, l'intensité I et la température T de la cellule 41 considérée.

Dans cette variante, l'équation discrétisée d'estimation de la variation de la capacité maximale de la cellule se serait alors exprimée sous la forme suivante :

$$\Delta Q(k) = g(SOC(k-1), \Delta Q(k-1), I(k-1), T(k-1)),$$

avec g une fonction représentative de la dynamique de variation de la capacité de la cellule.

**Revendications**

1. Procédé d'estimation du vieillissement d'au moins une cellule (41) de batterie d'accumulateurs (40), comportant une étape :

a) d'acquisition d'une tension (V$_{cell}$) aux bornes de ladite cellule (41) et d'une intensité (I) du courant traversant ladite cellule (41),

le procédé étant **caractérisé en ce qu'**il comporte une étape :

b) de calcul d'une capacité maximale (Q$_r$) et d'un niveau de charge (SOC) de ladite cellule (41) en fonction de la tension (V$_{cell}$) et de l'intensité (I) acquises à l'étape a),

le calcul étant réalisé par résolution :

- d'un système d'équations discrétisées correspondant à une modélisation de ladite cellule (41) sous la forme d'un circuit électrique (42) comportant, en série, une source de tension parfaite (E$_{eq}$), une résistance (R$_\Omega$), un premier couple de résistance (R$_{ct}$) et de capacité (C$_{dl}$) branchées en parallèle, et au moins un second couple de résistance (R$_i$) et de capacité (C$_i$) branchées en parallèle, et
- d'une équation discrétisée d'estimation de la variation de la capacité maximale (Q$_r$) de ladite cellule (41).

2. Procédé d'estimation selon la revendication précédente, dans lequel ledit système d'équations discrétisées s'exprime sous la forme suivante :

$$\begin{cases} SOC(k) = SOC(k-1) + \dfrac{(1+\Delta Q).I(k-1).T_e}{Q_n} \\[2mm] V_{dl}(k) = (1 - \dfrac{T_e}{R_{ct}C_{dl}}).V_{dl}(k-1) + \dfrac{I(k-1).T_e}{C_{dl}} \\[2mm] V_i(k) = (1 - \dfrac{T_e}{R_iC_i}).V_i(k-1) + \dfrac{I(k-1).T_e}{C_i}, \text{ avec } i = 1\dots N \end{cases}$$

$$V_{Cell}(k) = E_{eq}(k) + R_\Omega.I(k) + V_{dl}(k) + \sum_{i=1}^{N} V_i(k)$$

avec :

- T$_e$ une période d'échantillonnage considérée,
- k un indice incrémental,
- SOC le niveau de charge (SOC) de ladite cellule (41),
- I l'intensité (I) du courant traversant ladite cellule (41),
- ΔQ une fonction d'une capacité nominale (Q$_n$) en début de vie de la cellule (41) et la capacité maximale (Q$_r$) instantanée de la cellule (41),
- V$_{cell}$ la tension aux bornes du circuit électrique (42),
- V$_{dl}$ la tension aux bornes du premier couple de résistance (R$_{ct}$) et capacité (C$_{dl}$), dont les valeurs sont respectivement notées R$_{ct}$ et C$_{dl}$, et
- V$_i$ la tension aux bornes du second couple de résistance (R$_i$) et capacité (C$_i$), dont les valeurs sont respectivement notées R$_i$ et C$_i$.

3. Procédé d'estimation selon l'une des revendications précédentes, dans lequel ladite équation discrétisée d'estimation de la variation de la capacité maximale (Q$_r$) de ladite cellule (41) s'exprime en fonction d'un paramètre (ΔQ) relatif à une capacité nominale (Q$_n$) en début de vie de ladite cellule (41) et à la capacité maximale (Q$_r$) instantanée de ladite cellule (41).

4. Procédé d'estimation selon la revendication 3, dans lequel ladite équation discrétisée d'estimation de la variation de la capacité maximale (Q$_r$) de ladite cellule (41) s'exprime sous la forme suivante :

$$\Delta Q(k) = \Delta Q(k-1),$$

k étant un indice incrémental.

**EP 3 047 290 B1**

**5.** Procédé d'estimation selon la revendication 3, dans lequel ladite équation discrétisée d'estimation de la variation de la capacité maximale (Q$_r$) de ladite cellule (41) s'exprime sous la forme suivante :

$$\Delta Q(k) = g(SOC(k-1), \Delta Q(k-1), I(k-1), T(k-1)),$$

avec :

- k un indice incrémental,
- g une fonction représentative de la dynamique de variation de la capacité de la cellule (41),
- SOC le niveau de charge (SOC) de ladite cellule (41),
- I l'intensité (I) du courant traversant ladite cellule (41),
- T une température mesurée sur ladite cellule (41).

**6.** Procédé d'estimation selon l'une des revendications précédentes, dans lequel, à l'étape b), le calcul est réalisé en résolvant lesdites équations à l'aide d'un observateur d'état dont le vecteur d'état (x$_k$) comporte :

- le niveau de charge (SOC) de ladite cellule (41),
- la capacité maximale (Q) de ladite cellule (41),
- la tension (V$_{dl}$) aux bornes du premier couple de résistance (R$_{ct}$) et capacité (C$_{dl}$), et
- la tension (V$_i$) aux bornes de chaque couple i de résistance (R$_i$) et capacité (C$_i$).

**7.** Procédé d'estimation selon l'une des revendications précédentes, dans lequel, à l'étape b), le calcul est réalisé en résolvant lesdites équations à l'aide d'un observateur d'état dont le vecteur de sortie (y$_k$) comprend la tension (V$_{cell}$) aux bornes du circuit électrique (42).

**8.** Procédé d'estimation selon l'une des revendications précédentes, dans lequel il est prévu une étape supplémentaire c) de calcul d'un indicateur d'état de santé (SOH_E) de ladite cellule (41), en fonction de la capacité maximale (Q$_r$) de ladite cellule (41) calculée à l'étape b).

**9.** Procédé d'estimation selon la revendication précédente, dans lequel, à l'étape c), la valeur dudit indicateur d'état de santé (SOH_E) est modifiée seulement si la variation de la capacité maximale (Q$_r$) de ladite cellule (41) est inférieure à un seuil prédéterminé.

**10.** Procédé d'estimation selon l'une des deux revendications précédentes, dans lequel, à l'étape c), la valeur dudit indicateur d'état de santé (SOH_E) est modifiée seulement si la température mesurée (T) de ladite batterie d'accumulateurs (40) est comprise dans une plage de température de caractérisation en début de vie (T$_{min,carac}$ <T< T$_{max,carac}$) de ladite batterie d'accumulateurs (40).

**11.** Procédé d'estimation selon l'une des trois revendications précédentes, dans lequel, à l'étape c), la valeur dudit indicateur d'état de santé (SOH_E) est modifiée seulement si le niveau de charge (SOC) de ladite batterie d'accumulateurs (40) est compris dans une plage de caractérisation en début de vie (SOC$_{min,carac}$ <SOC< SOC$_{max,carac}$) de ladite batterie d'accumulateurs (40).

**12.** Procédé d'estimation selon l'une des quatre revendications précédentes, dans lequel, à l'étape c), la valeur dudit indicateur d'état de santé (SOH_E) est modifiée seulement si la tension (V$_{cell}$) acquise à l'étape a) est comprise dans une plage de tension de caractérisation en début de vie (V$_{min,carac}$ <V< V$_{max,carac}$) de ladite batterie d'accumulateurs (40).

**13.** Procédé d'estimation selon l'une des cinq revendications précédentes, dans lequel, à l'étape c), la valeur dudit indicateur d'état de santé (SOH_E) est modifiée seulement si l'intensité (I) acquise à l'étape a) est comprise dans une plage d'intensité de caractérisation en début de vie (I$_{min,carac}$ <I< I$_{max,carac}$) de ladite batterie d'accumulateurs (40).

**Patentansprüche**

1. Verfahren zur Schätzung der Alterung mindestens einer Zelle (41) eines Akkumulators (40), das einen folgenden Schritt beinhaltet:

   a) Erfassen einer Spannung ($V_{cell}$) an den Anschlüssen der Zelle (41) und einer Stärke (I) des Stroms, der durch die Zelle (41) fließt,
   wobei das Verfahren **dadurch gekennzeichnet ist, dass** es einen folgenden Schritt beinhaltet:
   b) Berechnen einer maximalen Kapazität ($Q_r$) und eines Ladestands (SOC) der Zelle (41) in Abhängigkeit von der in Schritt a) erfassten Spannung ($V_{cell}$) und Stärke (I),

   wobei das Berechnen durch das Lösen von Folgendem ausgeführt wird:

   - eines Systems diskretisierter Gleichungen, das einer Modellierung der Zelle (41) in Form einer elektrischen Schaltung (42) entspricht, die in Reihe eine perfekte Spannungsquelle ($E_{eq}$) , einen Widerstand ($R_\Omega$), ein erstes Paar aus einem Widerstand ($R_{ct}$) und einer Kapazität ($C_{dl}$), die parallel geschaltet sind, und mindestens ein zweites Paar aus einem Widerstand ($R_i$) und einer Kapazität ($C_i$), die parallel geschaltet sind, umfasst, und
   - einer diskretisierten Gleichung zur Schätzung der Veränderung der maximalen Kapazität ($Q_r$) der Zelle (41).

2. Verfahren zur Schätzung nach dem vorhergehenden Anspruch, wobei das System diskretisierter Gleichungen folgendermaßen ausgedrückt wird:

$$\begin{cases} SOC(k) = SOC(k-1) + \dfrac{(1+\Delta Q)\cdot I(k-1)\cdot T_e}{Q_n} \\[2mm] V_{dl}(k) = \left(1 - \dfrac{T_e}{R_{ct}C_{dl}}\right)\cdot V_{dl}(k-1) + \dfrac{I(k-1)\cdot T_e}{C_{dl}} \\[2mm] V_i(k) = \left(1 - \dfrac{T_e}{R_i C_i}\right)\cdot V_i(k-1) + \dfrac{I(k-1)\cdot T_e}{C_i}, \quad wobei\ i = 1\dots N \end{cases}$$

$$V_{Cell}(k) = E_{eq}(k) + R_\Omega \cdot I(k) + V_{dl}(k) + \sum_{i=1}^{N} V_i(k)$$

   wobei:

   - $T_e$ ein betrachteter Stichprobenzeitraum ist,
   - k ein Inkrementalindex ist,
   - SOC der Ladestand (SOC) der Zelle (41) ist,
   - I die Stärke (I) des Stroms ist, der durch die Zelle (41) fließt,
   - $\Delta Q$ eine Funktion einer Nennkapazität ($Q_n$) zu Beginn der Lebensdauer der Zelle (41) und der momentanen maximalen Kapazität ($Q_r$) der Zelle (41) ist,
   - $V_{cell}$ die Spannung an den Anschlüssen der elektrischen Schaltung (42) ist,
   - $V_{dl}$ die Spannung an den Anschlüssen des ersten Paares aus Widerstand ($R_{ct}$) und Kapazität ($C_{dl}$) ist, deren Werte jeweils mit $R_{ct}$ und $C_{dl}$ bezeichnet werden, und
   - $V_i$ die Spannung an den Anschlüssen des zweiten Paares aus Widerstand ($R_i$) und Kapazität ($C_i$) ist, deren Werte jeweils mit $R_i$ und $C_i$ bezeichnet werden.

3. Verfahren zur Schätzung nach einem der vorhergehenden Ansprüche, wobei die diskretisierte Gleichung zur Schätzung der Veränderung der maximalen Kapazität ($Q_r$) der Zelle (41) in Abhängigkeit von einem Parameter ($\Delta Q$) in Bezug auf eine Nennkapazität ($Q_n$) zu Beginn der Lebensdauer der Zelle (41) und die momentane maximale Kapazität ($Q_r$) der Zelle (41) ausgedrückt wird.

4. Verfahren zur Schätzung nach Anspruch 3, wobei die diskretisierte Gleichung zur Schätzung der Veränderung der maximalen Kapazität ($Q_r$) der Zelle (41) folgendermaßen ausgedrückt wird:

$$\Delta Q(k) = \Delta Q(k-1),$$

wobei k ein Inkrementalindex ist.

5. Verfahren zur Schätzung nach Anspruch 3, wobei die diskretisierte Gleichung zur Schätzung der Veränderung der maximalen Kapazität ($Q_r$) der Zelle (41) folgendermaßen ausgedrückt wird:

$$\Delta Q(k) = g\big(SOC(k-1), \Delta Q(k-1), I(k-1), T(k-1)\big),$$

wobei:

- k ein Inkrementalindex ist,
- g eine repräsentative Funktion der Veränderungsdynamik der Kapazität der Zelle (41) ist,
- SOC der Ladestand (SOC) der Zelle (41) ist,
- I die Stärke (I) des Stroms ist, der durch die Zelle (41) fließt,
- T eine an der Zelle (41) gemessene Temperatur ist.

6. Verfahren zur Schätzung nach einem der vorhergehenden Ansprüche, wobei in Schritt b) das Berechnen ausgeführt wird, indem die Gleichungen mit Hilfe eines Zustandsbeobachters gelöst werden, dessen Zustandsvektor ($x_k$) Folgendes beinhaltet:

- den Ladestand (SOC) der Zelle (41),
- die maximale Kapazität (Q) der Zelle (41),
- die Spannung ($V_{dl}$) an den Anschlüssen des ersten Paares aus Widerstand ($R_{ct}$) und Kapazität ($C_{dl}$) und
- die Spannung ($V_i$) an den Anschlüssen jedes Paares i aus Widerstand ($R_i$) und Kapazität ($C_i$) .

7. Verfahren zur Schätzung nach einem der vorhergehenden Ansprüche, wobei in Schritt b) das Berechnen ausgeführt wird, indem die Gleichungen mit Hilfe eines Zustandsbeobachters gelöst werden, dessen Ausgangsvektor ($y_k$) die Spannung ($V_{cell}$) an den Anschlüssen der elektrischen Schaltung (42) beinhaltet.

8. Verfahren zur Schätzung nach einem der vorhergehenden Ansprüche, wobei ein zusätzlicher Schritt c) zum Berechnen eines Indikators des Gesundheitszustands (SOH_E) der Zelle (41) in Abhängigkeit von der in Schritt b) berechneten maximalen Kapazität ($Q_r$) der Zelle (41) vorgesehen ist.

9. Verfahren zur Schätzung nach dem vorhergehenden Anspruch, wobei in Schritt c) der Wert des Indikators des Gesundheitszustands (SOH_E) nur dann modifiziert wird, wenn die Veränderung der maximalen Kapazität ($Q_r$) der Zelle (41) kleiner als ein vorgegebener Schwellenwert ist.

10. Verfahren zur Schätzung nach einem der zwei vorhergehenden Ansprüche, wobei in Schritt c) der Wert des Indikators des Gesundheitszustands (SOH_E) nur dann modifiziert wird, wenn die gemessene Temperatur (T) des Akkumulators (40) in einem Temperaturcharakterisierungsbereich zu Beginn der Lebensdauer ($T_{min,carac} < T < T_{max,carac}$) des Akkumulators (40) liegt.

11. Verfahren zur Schätzung nach einem der drei vorhergehenden Ansprüche, wobei in Schritt c) der Wert des Indikators des Gesundheitszustands (SOH_E) nur dann modifiziert wird, wenn der Ladestand (SOC) des Akkumulators (40) in einem Charakterisierungsbereich zu Beginn der Lebensdauer ($SOC_{min,carac} < SOC < SOC_{max,carac}$) des Akkumulators (40) liegt.

12. Verfahren zur Schätzung nach einem der vier vorhergehenden Ansprüche, wobei in Schritt c) der Wert des Indikators des Gesundheitszustands (SOH_E) nur dann modifiziert wird, wenn die in Schritt a) erfasste Spannung ($V_{cell}$) in einem Spannungscharakterisierungsbereich zu Beginn der Lebensdauer ($V_{min,carac} < V < V_{max,carac}$) des Akkumulators (40) liegt.

13. Verfahren zur Schätzung nach einem der fünf vorhergehenden Ansprüche, wobei in Schritt c) der Wert des Indikators des Gesundheitszustands (SOH_E) nur dann modifiziert wird, wenn die in Schritt a) erfasste Stärke (I) in einem Stärkecharakterisierungsbereich zu Beginn der Lebensdauer ($I_{min,carac} < I < I_{max,carac}$) des Akkumulators (40) liegt.

**Claims**

1. Method for estimating the ageing of at least one cell (41) of a storage battery (40), said method comprising the following step:

    a) acquiring a voltage ($V_{cell}$) at the terminals of said cell (41) and an amperage (I) of the current passing through said cell (41),
    the method being **characterized in that** it comprises the following step:
    b) calculating a maximum capacity ($Q_r$) and a state of charge (SOC) of said cell (41) in accordance with the voltage ($V_{cell}$) and the amperage (I) acquired in step a),

    the calculation being performed by resolving:

    - a system of discretized equations corresponding to a modeling of said cell (41) as an electric circuit (42) comprising, in series, an ideal voltage source ($E_{eq}$), a resistor ($R_\Omega$), a first resistor ($R_{ct}$) and capacitor ($C_{dl}$) pair connected in parallel, and at least one second resistor ($R_i$) and capacitor ($C_i$) pair connected in parallel, and
    - a discretized equation for estimating the variation of the maximum capacity ($Q_r$) of said cell (41).

2. Estimation method according to the preceding claim, wherein said system of discretized equations is expressed in the following form:

$$\begin{cases} SOC(k) = SOC(k-1) + \dfrac{(1+\Delta Q).I(k-1).T_e}{Q_n} \\ V_{dl}(k) = \left(1 - \dfrac{T_e}{R_{ct}C_{dl}}\right).V_{dl}(k-1) + \dfrac{I(k-1).T_e}{C_{dl}} \\ V_i(k) = \left(1 - \dfrac{T_e}{R_i C_i}\right).V_i(k-1) + \dfrac{I(k-1).T_e}{C_i}, \end{cases}$$

$$V_{Cell}(k) = E_{eq}(k) + R_\Omega.I(k) + V_{dl}(k) + \sum_{i=1}^{N} V_i(k)$$

where *i* = 1 ...*N* with:

    - $T_e$ a considered sampling period,
    - k an incremental index,
    - SOC the state of charge (SOC) of said cell (41),
    - I the amperage (I) of the current passing through said cell (41),
    - $\Delta Q$ a function of a nominal capacity ($Q_n$) in the early life of the cell (41) and the instantaneous maximum capacity ($Q_r$) of the cell (41),
    - $V_{cell}$ the voltage at the terminals of the electric circuit (42),
    - $V_{dl}$ the voltage at the terminals of the first resistor ($R_{ct}$) and capacitor ($C_{dl}$) pair, of which the values are denoted $R_{ct}$ and $C_{dl}$ respectively, and
    - $V_i$ the voltage at the terminals of the second resistor ($R_i$) and capacitor ($C_i$) pair, of which the values are denoted $R_i$ and $C_i$ respectively.

3. Estimation method according to any one of the preceding claims, wherein said discretized equation for estimating the variation of the maximum capacity ($Q_r$) of said cell (41) is expressed in accordance with a parameter ($\Delta Q$) relating to a nominal capacity ($Q_n$) in the early life of said cell (41) and to the instantaneous maximum capacity ($Q_r$) of said cell (41).

4. Estimation method according to Claim 3, wherein said discretized equation for estimating the variation of the maximum capacity ($Q_r$) of said cell (41) is expressed in the following form:

$$\Delta Q(k) = \Delta Q(k-1),$$

k being an incremental index.

5.  Estimation method according to Claim 3, wherein said discretized equation for estimating the variation of the maximum capacity ($Q_r$) of said cell (41) is expressed in the following form:

$$\Delta Q(k) = g(SOC(k-1), \Delta Q(k-1), I(k-1), T(k-1)),$$

where:

- k is an incremental index,
- g is a function representative of the dynamic of variation of the capacity of the cell (41),
- SOC is the state of charge (SOC) of said cell (41),
- I is the amperage (I) of the current passing through said cell (41), and
- T is a temperature measured across said cell (41).

6.  Estimation method according to one of the preceding claims, wherein in step b) the calculation is made by resolving said equations with the aid of a state observer of which the state vector ($x_k$) comprises:

- the state of charge (SOC) of said cell (41),
- the maximum capacity (Q) of said cell (41),
- the voltage ($V_{dl}$) at the terminals of the first resistor ($R_{ct}$) and capacitor ($C_{dl}$) pair, and
- the voltage ($V_i$) at the terminals of each pair i of resistor ($R_i$) and capacitor ($C_i$).

7.  Estimation method according to one of the preceding claims, wherein in step b) the calculation is made by resolving said equations with the aid of a state observer of which the output vector ($y_k$) comprises the voltage ($V_{cell}$) at the terminals of the electric circuit (42).

8.  Estimation method according to one of the preceding claims, wherein an additional step c) is provided, in which a state of health indicator (SOH_E) of said cell (41) is calculated in accordance with the maximum capacity ($Q_r$) of said cell (41) calculated in step b).

9.  Estimation method according to the preceding claim, wherein in step c) the value of said state of health indicator (SOH_E) is modified only if the variation of the maximum capacity ($Q_r$) of said cell (41) is lower than a predetermined threshold.

10. Estimation method according to either of the two preceding claims, wherein in step c) the value of said state of health indicator (SOH_E) is modified only if the measured temperature (T) of said storage battery (40) is within a characterization temperature range in the early life ($T_{min,charac} < T < T_{max,charac}$) of said storage battery (40).

11. Estimation method according to one of the three preceding claims, wherein in step c) the value of said state of health indicator (SOH_E) is modified only if the state of charge (SOC) of said storage battery (40) is within a characterization range in the early life ($SOC_{min,charac} < SOC < SOC_{max,charac}$) of said storage battery (40).

12. Estimation method according to one of the four preceding claims, wherein in step c) the value of said state of health indicator (SOH_E) is modified only if the voltage ($V_{cell}$) acquired in step a) is within a characterization voltage range in the early life ($V_{min,charac} < V < V_{max,charac}$) of said storage battery (40).

13. Estimation method according to one of the five preceding claims, wherein in step c) the value of said state of health indicator (SOH_E) is modified only if the amperage (I) acquired in step a) is within a characterization amperage range in the early life ($I_{min,charac} < I < I_{max,charac}$) of said storage battery (40).

Fig.1

**Fig.2**

**Fig.3**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2971854

**Littérature non-brevet citée dans la description**

- **REMMLINGER JURGEN.** *Identification of a bilinear and parameter-varying model for lithium-ion batteries by subspace methods*

- **DAN SIMON.** Optimal State Estimation. Wiley